# EUROPEAN PATENT SPECIFICATION

(11) **EP 1 030 543 B1**
(45) Date of publication and mention of the grant of the patent: **07.01.2004**
(21) Application number: 00103237.4
(22) Date of filing: 17.02.2000
(51) Int. Cl.: H05K 1/03

(54) **Non-woven fabric material and prepreg, and circuit board using the same**
Vliesstoffmaterial, vorimpregniertes Material und ein Leiterplattensubstrat aus diesem Material
Matériau non-tissé, matériau préimpregné, et un circuit imprimé de ce matériau

(30) Priority: 19.02.1999 JP 4120899
(43) Date of publication of application: 23.08.2000
(73) Proprietor: Matsushita Electric Industrial Co., Ltd., Kadoma-shi, Osaka 571 (JP)
(72) Inventor: Echigo, Fumio, Osaka-shi, Osaka 533-0013 (JP); Kawakita, Yoshihiro, Shijonawate-shi, Osaka 575-0051 (JP)
(74) Representative: Blumbach, Kramer & Partner GbR

(56) References cited:
- EP-A- 0 178 943
- EP-A- 0 295 816
- EP-A- 0 807 703
- WO-A-97/26665
- US-A- 4 588 615
- US-A- 5 888 627
- PATENT ABSTRACTS OF JAPAN vol. 1999, no. 10, 31 August 1999 (1999-08-31) & JP 11 128667 A (BRIDGESTONE CORP), 18 May 1999 (1999-05-18)

## Description

The present invention relates to a circuit board provided with a plurality of high density wirings having a high connecting reliability on either both sides or on the inner layer of a substrate. The circuit board has an excellent thermal resistance and moisture resistance, so that the substrate is not warped or twisted due to increased temperature, and various electronic components can be mounted on the substrate with a high connecting reliability. The present invention relates also to a nonwoven fabric material and a prepreg used for manufacturing the circuit board.

Recently, in the fields of industrial and consumer apparatuses, the demand for small and lightweight electronic apparatuses with improved functions is further increasing. Consequently, electronic circuits' components to be mounted on these electronic apparatuses, such as semiconductors and circuit boards also are required to have improved density and high performance. For example, for semiconductors such as LSI, trends for narrower pitches and increasing numbers of pins are proceeding rapidly due to the increasing degree of integration and the high performance. As a result, mounting components on circuit boards by conventional soldering becomes difficult. For solving the problem, a COB (chip on board) technique was developed and has been widely used. In this technique, semiconductor chips are not packaged with ceramics or resins as in conventional techniques, but bare chips are directly mounted with a high density on circuit boards.

For circuit boards that can include electronic components mounted thereon with high reliability, glass epoxy resin substrates have been widely used. Such glass epoxy resin substrates are produced by impregnating woven fabrics of glass fibers with thermal-resistant epoxy resins. However, the coefficient of thermal expansion of the glass epoxy resin substrate is at least about three times great as that of the silicon that composes semiconductor chips. Though this difference does not cause any serious troubles for mounting conventional packaged semiconductors, it can deteriorate connectability at electrically connected parts between circuit boards and semiconductor chips. Another problem is a poor processability in forming micropores at a high speed by using a drill or lasers, since recently, small through holes or small via holes are formed in accordance with a developed high density mounting technique to correspond with small electronic devices with high performance.

In order to deal with the above problems, methods for manufacturing circuit boards provided with novel configurations or circuit boards for high density wiring are developed. In one technique, short fibers prepared by cutting synthetic fibers to be a predetermined length are formed to be a sheet with either pulp fibers or a resin binder. This sheet is calendered to make a nonwoven fabric material. The nonwoven fabric material is impregnated with a thermosetting resin such as an epoxy resin, and semi-cured to make a prepreg for a circuit board. A circuit board including the nonwoven fabric material has a surface with improved smoothness, and it is lightweight and has a low dielectric constant compared to a conventional glass epoxy resin substrate. In addition, a circuit board including the nonwoven fabric material is reliable in electric connectability with micro electronic components such as semiconductor chips, and it allows formation of high density wirings that require fine wiring patterns. Well-known circuit boards include, for example, nonwoven papers impregnated with a phenol resin, and nonwoven fabrics of aromatic polyamide (aramid) impregnated with an epoxy resin. Among them, a circuit board manufactured from a prepreg of an aramid nonwoven fabric and a thermosetting epoxy resin is especially considered for a direct mounting of semiconductor bare chips and formation of high density wirings, since the coefficient of the thermal expansion is similar to that of silicon, and the connection is reliable. See, for example, Published Unexamined Japanese Patent Application (Tokkai-Sho) 61-160500, Tokkai-Sho 62-261190, Tokkai-Sho 62-273792, Tokkai-Sho 62-274688 and Tokkai-Sho 62-274689. The circuit boards have been widely used for various electronic apparatuses for consumer and industrial use. Various circuit boards have been applied to portable electronic apparatuses in consumer fields such as portable phones for a resin multilayer wiring substrate having an IVH structure in all the layers (Tokkai-Hei 6-268345) that can form via-hole conductors directly below the landing parts or between arbitrary layers, because of the characteristics such as low expansion, low dielectric constant, and light-weight, to provide small substrates and high density mounting.

However, for insulators including the conventional aramid nonwoven fabric and a thermosetting epoxy resin, the substrates including nonwoven fabrics as well as synthetic fiber materials are warped especially when the temperature rises. This warping may be caused by the characteristics of the resin. The binder of aramid fibers in the nonwoven fabric is a resin with low softening point (about 200°C), or a water-dispersible epoxy resin with a low softening point is used for a binder to bond fibers in formation of a nonwoven fabric. At a higher temperature, these binders lose the function to bond fibers stably, and displacement of the fibers causes warping or bending of the substrate.

Tokkai-Hei 10-37054 discloses a method for solving the above-mentioned problem. More specifically, materials for a nonwoven fabric are mixed with short fibers having no plasticity at rising temperature and fibers having plasticity before processing under an identical condition of heat-compression. In this method, the non-plastic fibers are hot-melt bonded with the thermoplastic fibers, and the substrate will be less warped. However, the thermal resistance of the circuit boards is not satisfactory since the binders include thermoplastic fibers whose softening point is relatively low.

JP-A-11-128 667 discloses a filter material for use as a deodorant to efficiently remove hot harmful components in exhaust gases. The filter comprises a cubic net of synthetic chemical fibres such as PP (polypropylene) forming an inner skeleton and a deodorant is attached to this with an inorganic binder such as colloidal silica.

In order to solve the conventional problems mentioned above, the present invention provides a nonwoven fabric having superior thermal resistance, moisture resistance, and dimensional stability; a prepreg and a circuit board using the same.

For this purpose, a nonwoven fabric material of the present invention is a nonwoven fabric including thermal-resistant synthetic fibers, in which short fibers are bound by using an inorganic binder.

It is preferable in the nonwoven fabric that the short fibers of the material are bound with the inorganic binder at the intersections.

Preferably in the nonwoven fabric, the thermal-resistant synthetic fibers are at least one kind of fibers selected from the group consisting of poly(p-phenylene-2,6-benzobisoxazole) (PBO) fibers, polybenzimidazole (PBI) fibers, aramid fibers, polytetrafluoroethylene (PTFE) fibers, and poly(p-phenylene-2,6-benzobisthiazole) (PBZ) fibers.

It is also preferable in the nonwoven fabric that the inorganic binder is a residue formed from either a solution of a low melting point glass or a water-dispersible colloidal solution in which at least either low melting point glass fibers or low melting point glass particles are dispersed. Another example of inorganic binders available for this purpose comprises silica, alumina, zirconia, or magnesia as the main component.

It is also preferable that the fibers are bound with a chemical covalent siloxane bonding.

It is also preferable that the content of the inorganic binder ranges from 5 to 40 weight parts when the thermal-resistant synthetic fibers are 100 weight parts.

It is also preferable that the fineness of the thermal-resistant synthetic fibers ranges from 0.25 to 4 denier, or the average fiber diameter ranges from 5 to 20 µm.

It is also preferable that the length of the thermal-resistant synthetic fibers ranges from 1 to 6mm.

It is also preferable that the nonwoven fabric is obtained by a wet formation method.

It is also preferable that the weight of the nonwoven fabric ranges from 20 to 100g/m².

It is also preferable that the average thickness of the nonwoven fabric ranges from 0.03 to 0.2mm.

It is also preferable that the nonwoven fabric material further comprises gaps for resin impregnation.

A prepreg of the present invention is prepared by further impregnating any one of the above-mentioned nonwoven fabrics with a resin varnish and drying.

It is preferable in the prepreg that the resin varnish is at least one selected from the group consisting of an epoxy resin, a polyimide resin, a phenol resin, a fluorine resin and a cyanate ester resin.

Preferably, the weight of the prepreg ranges from 40 to 200g/m².

Preferably, the average thickness of the prepreg ranges from 0.04 to 0.2mm.

A circuit board of the present invention is manufactured by using any one of the above-mentioned prepregs as an electric insulator.

Preferably, the weight of the circuit board ranges from 45 to 400g/m².

Preferably, the average thickness of the circuit board ranges from 0.05 to 2mm.

The nonwoven fabric of the present invention is produced by firmly bonding synthetic fibers with a binder including an inorganic material when forming a nonwoven fabric of thermal-resistant synthetic fibers, and a circuit board of the present invention is manufactured from a prepreg prepared by impregnating the nonwoven fabric material with a resin varnish and drying the nonwoven fabric material. The circuit board has an excellent dimensional stability even under a high temperature condition, and the substrate is prevented from being warped or damaged due to moisture absorption or some other factors.
FIG. 1 is a partially enlarged cross-sectional view of a nonwoven fabric material in a first embodiment of the present invention.
FIG. 2 is an enlarged cross-sectional view of an insulating substrate in the first embodiment.
FIG. 3 is a partially enlarged cross-sectional view of a prepreg in a second embodiment of the present invention.
FIGs. 4A-4F are cross-sectional views to show a process of manufacturing a circuit board in a third embodiment of the present invention.
FIGs. 5A-5F are cross-sectional views to show a process of manufacturing a circuit board having a multilayer wiring structure in a fourth embodiment of the present invention.

The present invention provides a nonwoven fabric material manufactured by binding short fibers including thermal-resistant synthetic fibers by using an inorganic material. A binder used for binding short fibers includes an inorganic material having a higher melting or softening point compared to conventional synthetic/organic materials such as water-dispersible epoxy resin. Therefore, the material is provided with high thermal resistance and moisture resistance. In addition, the circuit board will not warp or show deterioration in the electric properties due to moisture absorption even if the electronic apparatus is used under a severe temperature condition, and thus, excellent reliability is provided.

The synthetic fibers composing the nonwoven fabric are at least one kind of fibers selected from the group consisting of PBO fibers, PBI fibers, aramid fibers, PTFE fibers and PBZ fibers. Since these fibers have high thermal resistance and a water-proof property (moisture resistance), nonwoven fabric substrates including the fibers have excellent thermal resistance and moisture resistance as well as the functions provided by the inorganic binder.

The binder used here is a residue formed from either a solution of a low melting point glass or a water-dispersible colloidal solution including at least either low melting point glass fibers or low melting point glass particles dispersed therein. Since these solutions have a high softening point or melting point, binding between the short fibers composing the nonwoven fabric will not be loosened even if the circuit board is exposed to a high temperature. As a result, the insulating substrate will not suffer warping etc. and a high dimensional stability can be maintained.

As a prepreg is prepared by impregnating the nonwoven fabric material with a resin varnish and drying, circuit boards of the present invention, e.g. double-faced printed circuit boards and multilayer printed circuit boards have excellent thermal resistance and moisture resistance. The resin varnish can be at least one selected from the group consisting of an epoxy resin, a polyimide resin, a phenol resin, a fluorine resin and a cyanate ester resin. Accordingly, a prepreg with good processability in the manufacturing steps can be provided.

Circuit boards of the present invention include double-faced printed circuit boards and multilayer printed circuit boards with excellent thermal resistance and moisture resistance. Such circuit boards have excellent reliability in industrial or military electronic apparatuses used under severe conditions, as well as electronic apparatuses for consumer use.

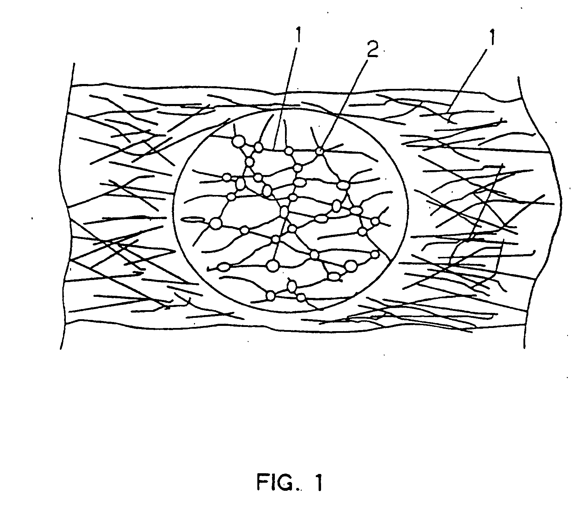

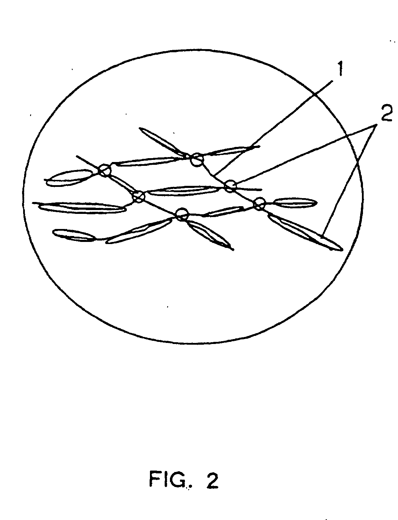

A nonwoven fabric material in a first embodiment of the present invention is explained below referring to FIGs. 1 and 2. FIG. 1 shows a sample of a nonwoven fabric material in the embodiment by partially enlarging microscopically. In FIG. 1, short fibers 1 including thermal-resistant synthetic fibers such as PBO and para-amide entangle with each other complicatedly in a formed sheet. At the numerous intersections of the short fibers 1 as shown inside the circle of FIG.1, low melting point glass 2 such as alkali metal silicate is condensed to firmly bind the short fibers 1. The softening point of this low melting point glass is adjustable in a wide temperature range by varying the composition, but typically, it is preferably set to be not less than 350°C. The upper limit of this temperature range is 650°C for PBO, while the same limit is 400°C for aramid. Components for the low melting point glass will be selected from an almost unlimited number of ingredients. The nonwoven fabric material including the thermal-resistant synthetic fibers bound by an inorganic binder having a high thermal resistance can maintain an excellent dimensional stability, thermal resistance and moisture resistance.

In addition, the inorganic binder (low melting point glass 2) can be coated not only at the intersections of the short fibers 1 but the remaining areas of the fibers by selecting the materials for the inorganic binder and controlling the blending rate with the nonwoven fabric and conditions for production. Consequently, the thermal resistance, moisture resistance and dimensional stability of the nonwoven fabric material can be further improved.

### Examples

The present invention will be explained below more specifically by referring to Examples, though the present invention is not limited by the Examples.

The Examples and Comparative Examples are evaluated in the following manner.
(1) Thermal resistance 1 (a degree of warping of an etched circuit board) is obtained by the steps of:
   preparing a circuit board by laminating three prepregs, heat-pressing the prepregs, placing copper foils on both sides to form a 20 × 20cm double-faced copper-clad laminate, removing the copper foils and
   placing the circuit board on a plate and measuring the degree of warping at the four corners of the circuit board in order to take the maximum value.
(2) Thermal resistance 2 (a variation of via resistance value at a reflow) is obtained by the steps of:
   dipping a circuit board formed with a wiring pattern in a 260°C solder bath (dipping for 30 seconds each time), and
   measuring variation in the resistance value per via from which excluding the resistance value of the wirings before and after the test.

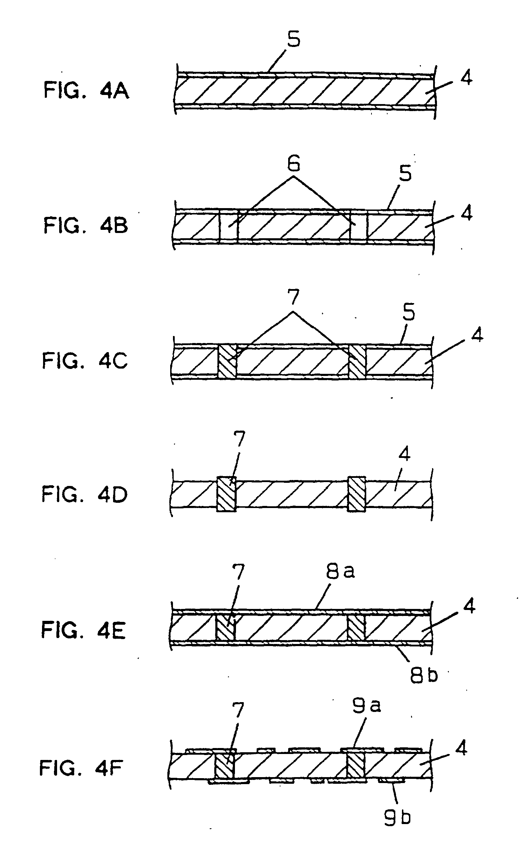

   The substrate for the evaluation is configured by linking a plurality of vias as shown in FIGs. 4F and 5F. In a normal measurement, resistance value of the wiring will be included in the resistance value of the vias. The inventors have prepared test patterns corresponding to the wiring length in order to excluding the resistance value of the wirings from the substrate resistance value and to obtain accurate resistance values of the vias. As a result, the sensitivity to the variation in via resistance values will less deteriorate even when the resistance value of the wirings is increased compared to that of the vias.
(3) Moisture resistance 1 (moisture absorption) is obtained by the steps of:
   preparing a circuit board by forming a wiring pattern and drying,
   leaving the circuit board under a saturated steam atmosphere at 121°C, 0.2 Pa for 24 hours, and
   measuring moisture absorption rate of the substrate by taking the increase in the weight caused by the moisture absorption.
(4) Moisture resistance 2 (variation of via resistance value under a Pressure Cooker Test) is obtained by the steps of:
   preparing a circuit board by forming a wiring pattern and drying,
   leaving the circuit board under a saturated steam atmosphere at 121°C, 0.2 Pa for 300 hours, and
   measuring variation in the resistance value per via from which excluding the resistance value of the wirings before and after the test.

The resistance value of the wirings should be excluded because of the same reason as the above evaluation (1).

### (Example 1)

PBO fibers, which were spun to have an appropriate fiber diameter ("Zylon" (trade name) supplied by TOYOBO CO., LTD.) were cut to prepare short fibers of 0.3-5 denier and about 1-10mm in length. The fibers were dispersed in water, mixed well, formed into a sheet of 70g/m² by a known technique and dried.

Subsequently, an aqueous solution of alkali metal silicate glass whose molecular formula is M₂O·nSiO₂ (M denotes an alkali metal) was prepared by adjusting the viscosity. The solution was sprayed on the both sides of the well-dried nonwoven fabric in order to impregnate the nonwoven fabric (100 weight parts) with 10 weight parts of the solution. The nonwoven fabric was dried well in a drying furnace, and calendered in a calender device having a pair of metal rolls under the following condition:
temperature: 300 to 400°C,
linear pressure: 200kg/cm,
speed: 4m/min.
Dehydration-condensation occurred among silanol of the alkali metal silicate glass by the heat during the calendering, and thus, siloxane bonds were generated among the molecules. At the intersections of the fibers entangled with each other at this time, the alkali metal silicate glass became an amorphous solid as shown in FIG. 1 to firmly bind the nonwoven fabric.

The obtained nonwoven fabric material was impregnated with 50-60 weight % of an epoxy resin, and dried by heat to be semi-cured (Stage B). The epoxy resin was a mixture of brominated bisphenol A epoxy resin (trade name: Epikote YL 6090) and bisphenol A·formaldehyde condensate epoxy resin (trade name: Epicure YLH 129) at a blending ratio of 2:1. Both resins are supplied by YUKA SHELL EPOXY CO.

The obtained prepreg was 140g/m² and 0.14mm in thickness.

### (Example 2)

PBI fibers spun to be 5-20 µm in diameter were prepared. The fineness was 1.5 denier and the fibers were cut previously to be 3-7mm in length. Para-amide fibers, which were pre-treated mechanically to make pulp, were mixed with the PBI short fibers and the mixture was dispersed in a colloidal solution including ultrafine particles or short fibers of water-dispersible low melting point glass dispersed therein, and the solution was homogenized well. Subsequently, the solution was formed into a sheet and the sheet was calendered under the same condition described in Example 1.

As shown in FIG. 2, in the obtained nonwoven fabric material, colloidal particles having a siloxane structure of -Si-O-Si- were adhered to the intersections and around the synthetic fibers. Siloxane bonding, which occurred due to dehydration-condensation of silanol groups on the particles, served to connect the intersections of the entangled fibers and also to coat the fibers.

The obtained nonwoven fabric material was impregnated with 50-60 weight % of an epoxy resin, and dried by heat to be semi-cured (Stage B). The epoxy resin was a mixture of brominated bisphenol A epoxy resin (trade name: Epikote YL 6090) and bisphenol A·formaldehyde condensate epoxy resin (trade name: Epicure YLH 129) at a blending ratio of 2:1. Both resins. are supplied by YUKA SHELL EPOXY CO.

The obtained prepreg was 140g/m² and 0.14mm in thickness.

### (Example 3)

PBZ fibers, which were spun to have an appropriate fiber diameter, were cut to prepare short fibers of 0.3-5 denier and about 1-10mm in length. The fibers were dispersed in water, mixed well, formed into a sheet of 70g/m² by a known technique and dried. Next, borosilicate lead glass powder was prepared by including respectively 10 weight % of Al₂O₃ and CaO, 30 weight % of SiO₂, 20 weight % of boric acid and 30 weight % of lead in general, and a paste was prepared by dissolving a synthetic binder (ethyl cellulose or an acrylic resin) in an organic solvent (e.g., butyl carbitol acetate). The paste was added to the borosilicate lead glass powder and kneaded to obtain a glass paste. The glass paste was sprayed on the both sides of the formed nonwoven fabric (100 weight parts) to impregnate the nonwoven fabric with 10 weight parts of the paste. After evaporate-removing the organic solvent and drying well in a drying furnace, the nonwoven fabric was calendered in a calender device having a pair of metal rolls under the following condition:
temperature: 300 to 400°C,
linear pressure: 200kg/cm,
speed: 4m/min.
Since a glass paste with a relatively high viscosity was used in Example 3, the glass solution was easily adhered to the intersections and to the fibers in the nonwoven fabric. The viscosity can be adjusted by varying the content of the organic solvent in order to control the adhesion of the glass.

The obtained nonwoven fabric material was impregnated with 50-60 weight % of an epoxy resin, and dried by heat to be semi-cured (Stage B). The epoxy resin was a mixture of brominated bisphenol A epoxy resin (trade name: Epikote YL 6090) and bisphenol A · formaldehyde condensate epoxy resin (trade name: Epicure YLH 129) at a blending ratio of 2:1. Both resins are supplied by YUKA SHELL EPOXY CO.

The obtained prepreg was 140g/m² and 0.14mm in thickness.

### (Example 4)

PBO short fibers, which were spun to have an appropriate fiber diameter, and PTFE fibers 12 µmin diameter were prepared. The fineness of the PBO fibers was 0.3-5 denier, and the PBO fibers were cut previously to be about 1-10mm, while the PTFE fibers were cut to be 4mm in length, These fibers were added and mixed in an aqueous colloidal solution including ultrafine particles or short fibers of water-dispersible low melting point glass, dispersed well to be homogenized. The solution was formed into a sheet of 100g/m² by a well-known technique. After drying well in a drying furnace, the nonwoven fabric was calendered in a calender device having a pair of metal rolls under the following condition:
temperature: 300 to 400°C,
linear pressure: 200kg/cm,
speed: 4m/min.

The obtained nonwoven fabric material was impregnated with 50-60 weight % of an epoxy resin, and dried by heat to be semi-cured (Stage B). The epoxy resin was a mixture of brominated bisphenol A epoxy resin (trade name: Epikote YL 6090) and bisphenol A·formaldehyde condensate epoxy resin (trade name: Epicure YLH 129) at a blending ratio of 2:1. Both resins are supplied by YUKA SHELL EPOXY CO.

The obtained prepreg was 140g/m² and 0.14mm in thickness.

### (Example 5)

For para-oriented aramid fibers, "Kevlar 49" (trade name) short fibers supplied by E.I. DuPont (fineness: 1.5 denier, fiber length: 3-7mm) were prepared. The fibers were dispersed in water, mixed well, formed into a sheet of 50g/m² by a known technique, and dried to obtain a nonwoven fabric. An aqueous solution of alkali metal silicate glass (molecular formula: M₂O·nSiO₂), which was previously adjusted to have a proper viscosity, was sprayed on both sides of the nonwoven fabric (100 weight parts) to impregnate the nonwoven fabric with 10 weight parts of the solution. The nonwoven fabric was dried well in a drying furnace before being calendered in a calender device having a pair of metal rolls under the following condition:
temperature: 300 to 400°C,
linear pressure: 200kg/cm,
speed: 4m/min.

The obtained nonwoven fabric material was impregnated with 50-60 weight % of an epoxy resin, and dried by heat to be semi-cured (Stage B). The epoxy resin was a mixture of brominated bisphenol A epoxy resin (trade name: Epikote YL 6090) and bisphenol A·formaldehyde condensate epoxy resin (trade name: Epicure YLH 129) at a blending ratio of 2:1. Both resins are supplied by YUKA SHELL EPOXY CO.

The obtained prepreg was 140g/m² and 0.14mm in thickness.

The inorganic binders described in Examples 1, 2, 4 and 5 were solutions of water-dispersible glass. Since synthetic fibers are water-repelling inherently, it is preferable that the synthetic fibers are pre-treated with a surfactant to adhere either glass particles or glass fibers at the intersections or the other.areas of the fibers by using the solution of water-dispersible glass. For further improving the waterproofing of thermoset water glass, curing agents are preferably used together to provide a firm bonding, so that the nonwoven fabric material of the present invention will have an improved thermal resistance. The curing agents include oxides or hydroxides of zinc, magnesium, calcium etc., silicofluorides of sodium, potassium, calcium etc., and phosphates of aluminum, zinc etc.

For showing properties of the nonwoven fabric materials in the above Examples, circuit boards manufactured from the nonwoven fabrics of the Examples were compared in the thermal resistance and moisture resistance with circuit boards manufactured by using conventional nonwoven fabric materials.

### (Comparative Example 1)

A PBO nonwoven fabric was prepared in the same manner of Example 1. An emulsified binder of a water-soluble epoxy resin was sprayed on the PBO nonwoven fabric. The nonwoven fabric was passed through a hot air zone of 120°C and dried to make a circuit board.

### (Comparative Example 2)

A circuit board was manufactured in the same manner of Comparative Example 1 except that the binder for the PBO nonwoven fabric was replaced with meta-aramid.

### (Comparative Example 3)

For para-oriented aramid fibers, "Kevlar 49" (trademark) supplied by E.I. DuPont was dispersed in water to form a sheet of a nonwoven fabric of 50g/m². An epoxy resin emulsion as a binder was sprayed on the nonwoven fabric sheet to be about 10 weight % as solid. The nonwoven fabric was dried continuously at 120°C, treated with an acrylic polymer, and calendered in a calender device having a pair of metal rolls at a temperature of 120°C so that a circuit board was manufactured.

### (Comparative Example 4)

A circuit board was manufactured in the same manner of Comparative Example 3 except that the binder for the para-oriented aramid nonwoven fabric was replaced with meta-aramid.

### (63) Evaluation results of Examples of the present invention and of the Comparative Examples are shown in the following Table 1.

**Table 1**

| | Warping degree (mm) | Flow resistance variation (%) | Moisture absorption (%) | PCT resistance variation (%) |
|---|---|---|---|---|
| Example 1 | 0.5 | 0 | 0.3 | 3 |
| Example 2 | 0.5 | 0 | 0.7 | 5 |
| Example 3 | 0.6 | 0 | 0.4 | 4 |
| Example 4 | 1.0 | 1 | 0.2 | 3 |
| Example 5 | 1.2 | 2 | 1.0 | 8 |
| Com. Ex. 1∗ | 10.7 | 5 | 1.9 | 25 |
| Com. Ex. 2 | 8.6 | 4 | 1.6 | 18 |
| Com. Ex. 3 | 12.1 | 7 | 2.7 | 48 |
| Com. Ex. 4 | 8.9 | 4 | 2.3 | 20 |

| | | | | |
|---|---|---|---|---|
| ∗Comparative Example | | | | |

As shown in Table 1, nonwoven fabric materials manufactured according to Examples of the present invention have excellent thermal resistance, moisture resistance and dimensional stability, since the nonwoven fabrics are manufactured by binding short fibers of thermal-resistant synthetic fibers with low melting point glass having excellent thermal resistance.

Similar effects can be obtained by using a glass paste including an inorganic binder and an organic binder. The inorganic binder is a powder or short fibers of phosphate-based water-dispersible glass represented with a chemical formula of M·H₂PO₄ (M=Al, Mg, Ca, Ba, Ti etc.) or crystalline borosilicate lead glass containing ZnO.

The following description is about a prepreg in a second embodiment of the present invention. The prepreg was prepared by mixing a catalyst and an organic solvent of proper contents in a resin varnish of an epoxy resin having the following composition, and adjusting the viscosity of the solution; impregnating the solution in any one of the nonwoven fabric materials of Examples 1-3 by using a coating machine; evaporating the solvent in a drying furnace, heating the epoxy resin to a certain temperature to a semi-cured state (Stage B).

| | | |
|---|---|---|
| Basic materials | Brominated bisphenol A epoxy resin | 75 weight parts |
| | Novolak phenol resin | 25 weight parts |
| Curing agent | Carbonyl diimidazole | 0.2 weight part |

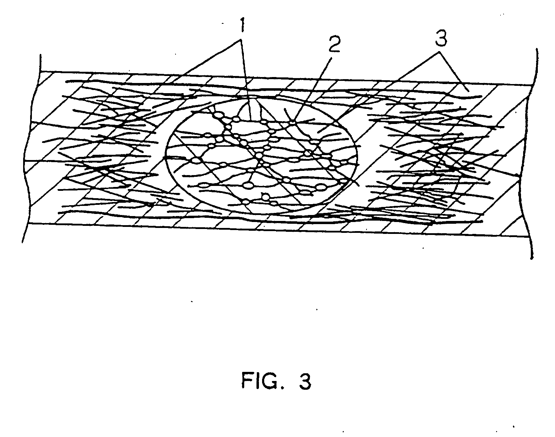

An excellent thermal-resistant prepreg for circuit boards is obtained by using thermosetting resins for an impregnation resin varnish such as a polyimide resin, a phenol resin, a fluorine resin and a cyanate ester resin as well as the above-mentioned epoxy resin. The resins can be used alone or mixed with each other. FIG. 3 is a cross-sectional view of a prepreg that is formed by impregnating the nonwoven fabric in FIG. 1 with a resin varnish, compressing with heat to be semi-curing. A resin varnish 3 including an epoxy resin is impregnated in the gaps of the entangled nonwoven fabric fibers 1 whose intersections are bound with the inorganic binder 2.

A circuit board in a third embodiment of the present invention is explained below referring to FIGs. 4A-4F. First, a prepreg 4 is prepared from any one of the nonwoven fabric materials described in Examples 1-3 by impregnating the nonwoven fabric with a thermosetting resin such as an epoxy resin to semi-cure the fabric. As shown in FIG. 4A, resin films 5 such as polyethylene terephthalate are stuck to the both surfaces of the prepreg 4. Penetrations 6 are formed by using a laser etc. at predetermined positions on the prepreg 4 (FIG. 4B), and an electroconductive paste 7 for via-hole filling is filled in the penetrations 6 by a printing method (FIG. 4C). After peeling off the resin films 5 (FIG. 4D), copper foils (8a. 8b) are placed on the both surfaces of the prepreg 4 as shown in FIG. 4E, and the electroconductive paste 7 and the semi-cured prepreg 4 are cured completely by applying pressure (20-50 kg/cm²) and heat (from 170 to 260°C) from the both sides for 60 minutes. The condition of the pressure and heat should be modified corresponding to the impregnated resin varnish. Subsequently, the copper foils (8a, 8b) are patterned in a conventional photolithography to form predetermined wirings (9a, 9b) on both surfaces as shown in FIG. 4F so that a circuit board is provided.

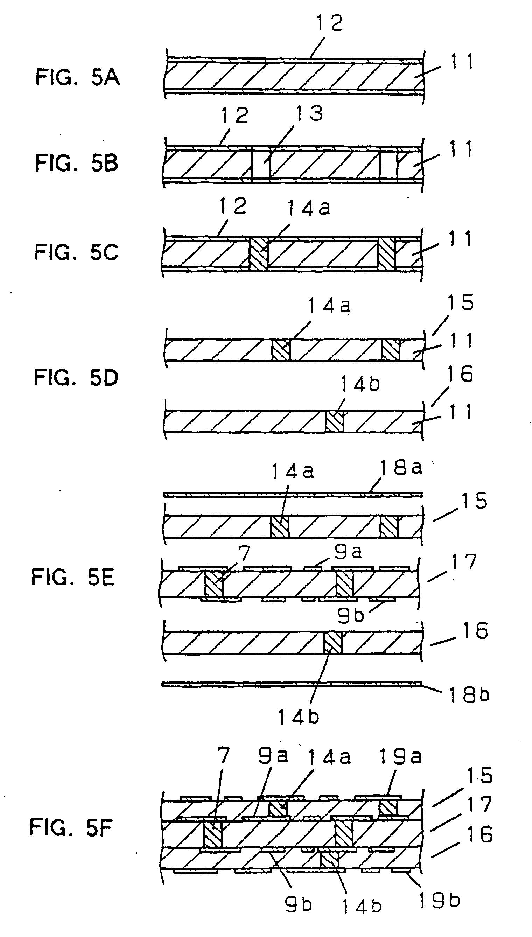

Next, a circuit board provided with a multilayer wiring structure in a fourth embodiment of the present invention is described below, referring to FIGs. 5A-5F. First, a prepreg 11 is prepared from any one of the nonwoven fabric materials described in Examples 1-3 by impregnating the nonwoven fabric with a thermosetting resin such as an epoxy resin to semi-cure the fabric. As shown in FIG. 5A, resin films 12 such as polyethylene terephthalate are stuck to the both surfaces of the prepreg 11. Penetrations 13 are formed by using a laser etc. at predetermined positions on the prepreg 11 (FIG. 5B), and an electroconductive paste 14a for via-hole filling (via-hole conductor) is filled in the penetrations 13 by a printing method (FIG. 5C). By peeling off the resin films 12, an intermediate connector 15 and an intermediate connector 16 are obtained as shown in FIG. 5D. The intermediate connector 16 formed similarly has a via-hole connector 14b.

As shown in FIG. 5E, the intermediate connectors 15 and 16 are positioned precisely on both sides of a double-faced printed circuit board 17 in FIG. 4F. Copper foils 18a and 18b are further laminated on both the sides, and the laminates are compressed with heat to adhere the double-faced printed circuit board 17 and the copper foils (18a, 18b) through the intermediate connectors (15, 16). Subsequently, the copper foils (18a, 18b) are etched to have predetermined patterns in a conventional photolithography in order to form wirings (19a, 19b) as shown in FIG. 5F. As a result, a circuit board having a four-layered wiring structure is obtained, in which the wirings (9a, 9b) and wirings (19a, 19b) are connected through layers by the plural via-hole conductors 7, 14a and 14b.

As mentioned above, nonwoven fabric materials and prepregs in the present invention are provided by integrating nonwoven fabrics composed of thermal-resistant synthetic fibers with a binder including inorganic materials. Therefore, circuit boards including the nonwoven fabrics and prepregs are excellent in thermal resistance and moisture resistance.

## Claims

1. A nonwoven fabric material of short fibers comprising thermal-resistant synthetic fibers, wherein the short fibers are bound with an inorganic binder.

2. The nonwoven fabric material according to claim 1, wherein the short fibers are bound with the inorganic binder at the intersections.

3. The nonwoven fabric material according to claim 1 or 2, wherein the thermal-resistant synthetic fibers are at least one kind of fibers selected from the group consisting of poly(p-phenylene-2,6-benzobisoxazole) fibers, polybenzimidazole fibers, aramid fibers, polytetrafluoroethylene fibers, and poly(p-phenylene-2,6-benzobisthiazole) fibers.

4. The nonwoven fabric material according to any one of claims 1 to 3, wherein the inorganic binder is a residue formed from either a solution of low melting point glass or a water-dispersible colloidal solution in which at least one of fibers of low melting point glass or particles of low melting point glass are dispersed.

5. The nonwoven fabric material according to any one of claims 1 to 4, wherein the fibers are bound with a chemical covalent siloxane bonding.

6. The nonwoven fabric material according to any one of claims 1 to 5, wherein the content of the inorganic binder ranges from 5 to 40 weight parts when the thermal-resistant synthetic fibers are 100 weight parts.

7. The nonwoven fabric material according to any one of claims 1 to 6, wherein the fineness of the thermal-resistant synthetic fibers ranges from 0.25 to 4 denier.

8. The nonwoven fabric material according to any one of claims 1 to 7, wherein the length of the thermal-resistant synthetic fibers ranges from 1 to 6mm.

9. The nonwoven fabric material according to any one of claims 1 to 8, wherein the nonwoven fabric is obtained by a wet formation method.

10. The nonwoven fabric material according to any one of claims 1 to 9, wherein the weight of the nonwoven fabric ranges from 20 to 100g/m².

11. The nonwoven fabric material according to any one of claims 1 to 10, wherein the average thickness of the nonwoven fabric ranges from 0.03 to 0.2mm.

12. The nonwoven fabric material according to any one of claims 1 to 11, wherein the nonwoven fabric material further comprises gaps for resin impregnation.

13. A prepreg comprising the nonwoven fabric according to any one of the claims 1 to 12 and an impregnation with a resin varnish applied to said nonwoven fabric and dried.

14. The prepreg according to claim 13, wherein the resin varnish is at least one selected from the group consisting of an epoxy resin, a polyimide resin, a phenol resin, a fluorine resin and a cyanate ester resin.

15. The prepreg according to claim 13 or 14, wherein the weight of the prepreg ranges from 40 to 200g/m².

16. The prepreg according to any one of claims 13 to 15, wherein the average thickness of the prepreg ranges from 0.04 to 0.2mm.

17. A circuit board comprising the prepreg according to any one of the claims 13 to 16 as an electric insulator.

18. The circuit board according to claim 17, wherein the weight of the circuit board ranges from 45 to 400g/m².

19. The circuit board according to claim 17 or 18, wherein the average thickness of the circuit board ranges from 0.05 to 2mm.

## Patentansprüche

1. Vliesstoff-Material aus kurzen Fasern, die wärmebeständige synthetische Fasern umfassen, worin die kurzen Fasern mit einem anorganischen Bindemittel gebunden sind.

2. Vliesstoff-Material nach Anspruch 1, worin die kurzen Fasern mit dem anorganischen Bindemittel an den Knotenpunkten gebunden sind.

3. Vliesstoff-Material nach Anspruch 1 oder 2, worin die wärmebeständigen synthetischen Fasern wenigstens eine Art von Fasern sind, die gewählt sind aus der Gruppe, die besteht aus Poly-(p-phenylen-2,6-benzobisoxazol-) Fasern, Polybenzimidazol-Fasern, Aramid-Fasern, Polytetrafluorethylen-Fasern und Poly-(p-phenylen-2,6-benzobisthiazol-) Fasern.

4. Vliesstoff-Material nach einem der Ansprüche 1 bis 3, worin das anorganische Bindemittel ein Rest ist, der gebildet ist, der gebildet ist aus entweder einer Lösung eines Glases mit niedrigem Schmelzpunkt oder einer in Wasser dispergierbaren kolloidalen Lösung, in der wenigstens ein Material aus Fasern eines Glases mit einem niedrigen Schmelzpunkt oder Teilchen eines Glases mit einem niedrigen Schmelzpunkt dispergiert ist.

5. Vliesstoff-Material nach einem der Ansprüche 1 bis 4, worin die Fasern mit einer chemischen kovalenten Siloxan-Bindung gebunden sind.

6. Vliesstoff-Material nach einem der Ansprüche 1 bis 5, worin der Gehalt an anorganischem Bindemittel im Bereich von 5 bis 40 Gew.-Teilen liegt, wenn die Menge an wärmebeständigen synthetischen Fasern 100 Gew.-Teile ist.

7. Vliesstoff-Material nach einem der Ansprüche 1 bis 6, worin die Feinheit der wärmebeständigen synthetischen Fasern im Bereich von 0,25 bis 4 denier liegt.

8. Vliesstoff-Material nach einem der Ansprüche 1 bis 7, worin die Länge der wärmebeständigen synthetischen Fasern im Bereich von 1 bis 6 mm liegt.

9. Vliesstoff-Material nach einem der Ansprüche 1 bis 8, worin der Vliesstoff durch ein Naßherstellungsverfahren erhalten wird.

10. Vliesstoff-Material nach einem der Ansprüche 1 bis 9, worin das Gewicht des Vliesstoffs im Bereich von 20 bis 100 g/m² liegt.

11. Vliesstoff-Material nach einem der Ansprüche 1 bis 10, worin die mittlere Dicke des Vliesstoffs im Bereich von 0,03 bis 0,2 mm liegt.

12. Vliesstoff-Material nach einem der Ansprüche 1 bis 11, worin das Vliesstoff-Material weiter Zwischenräume für ein Imprägnieren mit Harz umfaßt.

13. Prepreg umfassend den Vliesstoff nach einem der Ansprüche 1 bis 12 und eine Imprägnierung mit einem Tränkharz, das auf den Vliesstoff aufgebracht und getrocknet wurde.

14. Prepreg nach Anspruch 13, worin das Tränkharz wenigstens eines ist, das gewählt ist aus der Gruppe, die besteht aus einem Epoxy-Harz, einem Polyimid-Harz, einem Phenol-Harz, einem Fluor-Harz und einem Cyanatester-Harz.

15. Prepreg nach Anspruch 13 oder 14, worin das Gewicht des Prepregs im Bereich von 40 bis 200 g/m² liegt.

16. Prepreg nach einem der Ansprüche 13 bis 15, worin die mittlere Dicke des Prepregs im Bereich von 0,04 bis 0,2 mm liegt.

17. Leiterplatte umfassend das Prepreg nach einem der Ansprüche 13 bis 16 als elektrischen Isolator.

18. Leiterplatte nach Anspruch 17, worin das Gewicht der Leiterplatte im Bereich von 45 bis 400 g/m² liegt.

19. Leiterplatte nach Anspruch 17 oder 18, worin die mittlere Dicke der Leiterplatte im Bereich von 0,05 bis 2 mm liegt.

## Revendications

1. Matériau d'étoffe non tissée constitué de fibres courtes comprenant des fibres synthétiques thermiquement résistantes, dans lequel les fibres courtes sont liées avec un liant inorganique.

2. Matériau d'étoffe non tissée selon la revendication 1, dans lequel les fibres courtes sont liées avec le liant inorganique au niveau des intersections.

3. Matériau d'étoffe non tissée selon la revendication 1 ou 2, dans lequel les fibres synthétiques thermiquement résistantes sont au moins un type de fibres choisi parmi le groupe constitué de fibres de poly(p-phénylène-2,6-benzobisoxazole), de fibres de polybenzimidazole, de fibres aramide, de fibres de polytétrafluoroéthylène et de fibres de poly(p-phénylène-2,6-benzobisthiazole).

4. Matériau d'étoffe non tissée selon l'une quelconque des revendications 1 à 3, dans lequel le liant inorganique est un résidu formé à partir soit d'une solution d'un verre à faible point de fusion, soit d'une solution colloïdale pouvant être dispersée dans l'eau, où les éléments d'au moins un ensemble parmi des fibres du verre à faible point de fusion ou des particules du verre à faible point de fusion sont dispersés.

5. Matériau d'étoffe non tissée selon l'une quelconque des revendications 1 à 4, dans lequel les fibres sont liées par une liaison chimique siloxane covalente.

6. Matériau d'étoffe non tissée selon l'une quelconque des revendications 1 à 5, dans lequel la teneur en liant inorganique varie de 5 à 40 parties en poids lorsque les fibres synthétiques thermiquement résistantes constituent 100 parties en poids.

7. Matériau d'étoffe non tissée selon l'une quelconque des revendications 1 à 6, dans lequel la finesse des fibres synthétiques thermiquement résistantes varie de 0,25 à 4 deniers.

8. Matériau d'étoffe non tissée selon l'une quelconque des revendications 1 à 7, dans lequel la longueur des fibres synthétiques thermiquement résistantes varie de 1 à 6 mm.

9. Matériau d'étoffe non tissée selon l'une quelconque des revendications 1 à 8, dans lequel l'étoffe non tissée est obtenue par un procédé de formation par voie humide.

10. Matériau d'étoffe non tissée selon l'une quelconque des revendications 1 à 9, dans lequel le poids de l'étoffe non tissée varie de 20 à 100 g/m².

11. Matériau d'étoffe non tissée selon l'une quelconque des revendications 1 à 10, dans lequel l'épaisseur moyenne de l'étoffe non tissée varie de 0,03 à 0,2 mm.

12. Matériau d'étoffe non tissée selon l'une quelconque des revendications 1 à 11, dans lequel le matériau d'étoffe non tissée comprend en outre des espacements pour une imprégnation de résine.

13. Pré-imprégné comprenant l'étoffe non tissée selon l'une quelconque des revendications 1 à 12 et une imprégnation avec un vernis de résine appliqué à ladite étoffe non tissée et séché.

14. Pré-imprégné selon la revendication 13, dans lequel le vernis de résine est au moins une résine choisie parmi le groupe constitué d'une résine époxy, d'une résine de polyimide, d'une résine phénolique, d'une résine fluorée et d'une résine d'ester de cyanate.

15. Pré-imprégné selon la revendication 13 ou 14, dans lequel le poids du pré-imprégné varie de 40 à 200 g/m².

16. Pré-imprégné selon l'une quelconque des revendications 13 à 15, dans lequel l'épaisseur moyenne du pré-imprégné varie de 0,04 à 0,2 mm.

17. Carte imprimée comprenant le pré-imprégné selon l'une quelconque des revendications 13 à 16 en tant qu'isolant électrique.

18. Carte imprimée selon la revendication 17, dans lequel le poids de la carte imprimée varie de 45 à 400 g/m².

19. Carte imprimée selon la revendication 17 ou 18, dans lequel l'épaisseur moyenne de la carte imprimée varie de 0,05 à 2 mm.
